# EUROPEAN PATENT APPLICATION

(11) **EP 1 429 168 A2**
(43) Date of publication of application: **16.06.2004**
(21) Application number: 03257695.1
(22) Date of filing: 08.12.2003
(51) Int. Cl.: G02B 7/02

(54) **Image sensing device and portable terminal**

(30) Priority: 13.12.2002 JP 2002362708
(71) Applicant: KONICA MINOLTA HOLDINGS, INC., Tokyo 100-0005 (JP)
(72) Inventor: Saito, Masashi, Hachioji-shi Tokyo (JP); Atarashi, Yuuichi, Hachioji-shi Tokyo (JP)
(74) Representative: Nicholls, Michael John

(57) **Abstract**

This invention relates to an image sensing device that can be manufactured well without being limited by the size or shape of an optical member, an image sensing element, and a substrate, and a portable terminal incorporating the same. An image sensing device of this invention includes a substrate having an image sensing element, and an optical member for forming an image of an object on an image sensing region of the image sensing element. The optical member includes a lens member, and a lens support member which has a support for supporting the lens member and which is arranged to abut against an image non-sensing region of the image sensing element.

## Description

### BACKGROUND OF THE INVENTION

### FIELD OF THE INVENTION:

The present invention relates to an image sensing device that can be mounted in a portable cellular phone set, a personal computer, or the like, and a portable terminal.

### DESCRIPTION OF THE PRIOR ART:

In recent years, a compact, high-performance image sensing device that can be mounted in a portable cellular phone set, a personal computer, or the like has been developed.

In a conventional image sensing device of this type, for example, an electrical component such as an A/D converter or driver, a CCD bear chip (image sensing element) to be connected to an image processing IC circuit, and the like are attached to a substrate. Also, a lens portion (optical member) having an imaging lens and a leg for enabling arrangement on the substrate are disposed (see, e.g., Japanese Unexamined Patent Publication No. 9-284617).

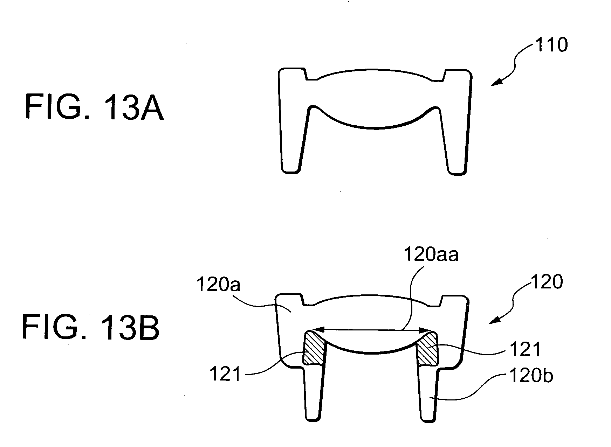

In the image sensing device disclosed in the above reference, in Fig. 13B, although the size of an imaging lens 120a of a lens portion is equal to that of a lens portion 110 shown in Fig. 13A, as a CCD bear chip and substrate (neither are shown) are made more compact, legs 120b of a lens portion 120 must be positioned on the inner side of a lens effective diameter 120aa and must abut against the outer side of the image sensing area of the CCD bear chip. In this case, only those portions of the legs 120b of the lens portion 120 which abut against the substrate must be formed small. Then, the legs 120b extend from inside the effective diameter 120aa of the imaging lens 120a, thus forming undercuts 121. Due to the limitation of the mold, however, it is impossible to mold a lens portion 120 having such a shape. Therefore, it is difficult to form a lens portion (optical member) that flexibly copes with a change in size or shape of the CCD bear chip or substrate.

### SUMMARY OF THE INVENTION

The present invention has been made in view of the situations of the prior art described above, and has as its object to provide an image sensing device that can be manufactured well without being limited by the size or shape of an optical member, an the image sensing element, and a substrate, and a portable terminal incorporating the same.

In order to achieve the above object, according to the first aspect of the present invention, there is provided an image sensing device comprising a substrate having an image sensing element, and an optical member for forming an image of an object on an image sensing region of the image sensing element, wherein the optical member comprises
a lens member, and
a lens support member which has a support for supporting the lens member and which is arranged to abut against an image non-sensing region of the image sensing element.

In the first aspect, the optical member is constituted by the lens member, and the lens support member which has the support for supporting the lens member and which is arranged to abut against the image non-sensing region of the image sensing element. When the lens support member to be arranged between the lens member and the image sensing element and substrate are changed when necessary, the image sensing device is not limited by the relationship, e.g., the size or shape, of the lens member, the image sensing element, and the substrate. This increases the degrees of freedom in the manufacture of the image sensing device.

According to the second aspect of the present invention, there is provided an image sensing device comprising a substrate having an opening, an image sensing element attached to a lower surface of the substrate to close at least part of the opening, and an optical member for forming an image of an object on an image sensing region of the image sensing element, wherein the optical member comprises
a lens member, and
a lens support member which has a support for supporting the lens member and which is arranged to abut against an image non-sensing region of the image sensing element from an upper surface of the substrate through the opening.

In the second aspect, the lens support member of the optical member that focuses incident light onto the image sensing element is attached such that it abuts against the upper surface of the image sensing element from the upper surface of the substrate through the opening. Thus, the image sensing device realizes reduction in profile by an amount corresponding to the thickness of the substrate. The optical member is constituted by the lens member, and the lens support member which has the support for supporting the lens member. Thus, when the lens support member to be interposed between the lens member and the image sensing element is changed when necessary, the manufacture of the image sensing device is realized without being limited by the relationship, e.g., the size or shape, of the lens member, the image sensing element, the substrate, and the like. This increases the degrees of freedom in the manufacture.

According to the third aspect of the present invention, in the image sensing device according to the first or second aspect, there is provided an image sensing device wherein the outer end of the support is located on the outer side of the image sensing element.

In the third aspect, the same effect as that of the image sensing device according to the first or second aspect can be obtained. Moreover, particularly, for example, when the lens portion is larger than the image sensing element and the side end of the support is located on the outer side of the image sensing element, the image sensing device can be manufactured without any problem. Thus, the image sensing element can be formed small regardless of the size of the lens member. This realizes downsizing of the image sensing device.

According to the fourth aspect of the present invention, in the image sensing device according to any one of the first to third aspects, there is provided an image sensing device wherein, in the support, the lens member fits with the lens support member.

In the fourth aspect of the present invention, the same effect as that of the image sensing device according to any one of the first to third aspects can be obtained. Moreover, particularly in the support, as the lens member is fitted with the lens support member, the lens member and the lens support member are fixed at predetermined positions. This stabilizes the dimensional accuracy of the optical member, so that a predetermined optical function can be achieved.

According to the fifth aspect of the present invention, in the image sensing device according to the fourth aspect, there is provided an image sensing device wherein the lens member has a projection projecting in a direction perpendicular to a direction of an optical axis, and the support has a recess which is to fit with the projection of the lens member and which opens upward.

In the fifth aspect, the same effect as that of the image sensing device according to the fourth aspect can be obtained. Moreover, particularly, the lens member has the projection projecting in the direction perpendicular to the direction of the optical axis, and the support has the recess which is to fit with the projection and which opens upward. Thus, the lens member can be fitted from above. This realizes facilitation of the manufacture.

According to the sixth aspect of the present invention, in the image sensing device according to any one of the first to fifth aspects, there is provided an image sensing device wherein the lens support member has light-shielding properties.

In the sixth aspect, the same effect as that of the image sensing device according to any one of the first to fifth aspects can be obtained. Moreover, particularly, since the lens member has the light-shielding properties, internal reflection against the lens member can be prevented.

According to the seventh aspect of the present invention, in the image sensing device according to any one of the first to sixth aspects, there is provided an image sensing device wherein at least one of an aperture plate and an IR cut filter is inserted between the lens member and the lens support member.

In the seventh aspect, the same effect as that of the image sensing device according to any one of the first to sixth aspects can be obtained. Moreover, an image sensing device in which particularly at least one of the aperture plate and the IR cut filter is inserted between the lens member and the lens support member can be manufactured.

According to the eighth aspect of the present invention, in the image sensing device according to any one of the first to seventh aspects, there is provided an image sensing device wherein an abutting surface of the lens support member which abuts against the image non-sensing region of the image sensing element has a uniform three-dimensional surface.

In the eighth aspect, the same effect as that of the image sensing device according to any one of the first to seventh aspects can be obtained. Moreover, particularly, the abutting surface of the lens support member which abuts against the image non-sensing region of the image sensing element has the uniform three-dimensional surface. Thus, the lens support member and the image sensing element form multi-point contacts, so that the load of the lens support member can be dispersed, which is preferable.

According to the ninth aspect of the present invention, there is provided an image sensing device comprising an image sensing portion including an image sensing element having a photoelectric converting portion, a substrate for holding the image sensing element and having an external connection terminal for an electrical signal, an optical member for forming an image of an object on the photoelectric converting portion, and a housing having an opening and made of a light-shielding member to cover the optical member, the optical member having a height of not more than 10 mm in a direction of an optical axis, wherein the optical member comprises
a lens member, and
a lens support member for supporting the lens member and arranged to abut against an image non-sensing region of the image sensing element.

In the ninth aspect, in the comparatively compact image sensing device in which the optical member has the height of not more than 10 mm in the direction of the optical axis, the optical member comprises the lens member and the lens support member. When the lens support member to be interposed between the lens member and the image sensing element is changed when necessary, the manufacture of the image sensing device is realized without being limited by the relationship, e.g., the size or shape, of the lens member, the image sensing element, the substrate, and the like. This increases the degrees of freedom in the manufacture.

According to the tenth aspect of the present invention, there is provided a portable terminal wherein the image sensing device according to any one of the first to ninth aspects is mounted in a case thereof.

In the tenth aspect, in the portable terminal in which the image sensing device according to any one of the first to ninth aspects is mounted in the case thereof, the degrees of freedom in the manufacture increase because of its image sensing device.

The above and many other objects, features and advantages of the present invention will become manifest to those skilled in the art upon making reference to the following detailed description and accompanying drawings in which preferred embodiments incorporating the principle of the present invention are shown by way of illustrative examples.

### BRIEF DESCRIPTION OF THE DRAWINGS

Fig. 1 is a perspective view of an image sensing device according to the first embodiment of the present invention;
Fig. 2 is a partially omitted sectional view taken along a section II of the image sensing device shown in Fig. 1;
Fig. 3 is a perspective view of an optical member;
Fig. 4 is an exploded perspective view showing the optical member and an image sensing element which are provided to the image sensing device;
Fig. 5 is an exploded perspective view showing an optical member according to the first modification and the image sensing element;
Fig. 6 is an exploded perspective view showing an optical member according to the second modification;
Fig. 7 is an exploded perspective view showing an optical member according to the third modification;
Fig. 8 is an exploded perspective view showing an optical member according to the fourth modification and the image sensing element;
Fig. 9 is a partially omitted sectional view for explaining an image sensing device according to the second embodiment;
Fig. 10 is a plan view of the substrate and image sensing element of the image sensing device shown in Fig. 9;
Fig. 11 is a partially omitted sectional view for explaining an image sensing device according to the third embodiment;
Figs. 12A and 12B are a front view and a rear view, respectively, showing an example of a portable cellular phone set incorporating an image sensing device of the present invention; and
Figs. 13A and 13B are views for explaining a conventional optical member and its modification, respectively.

### DETAILED DESCRIPTION OF THE PREFERRED EMBODIMENTS

Several preferred embodiments of the present invention will be described in detail with reference to the accompanying drawings.

### First Embodiment:

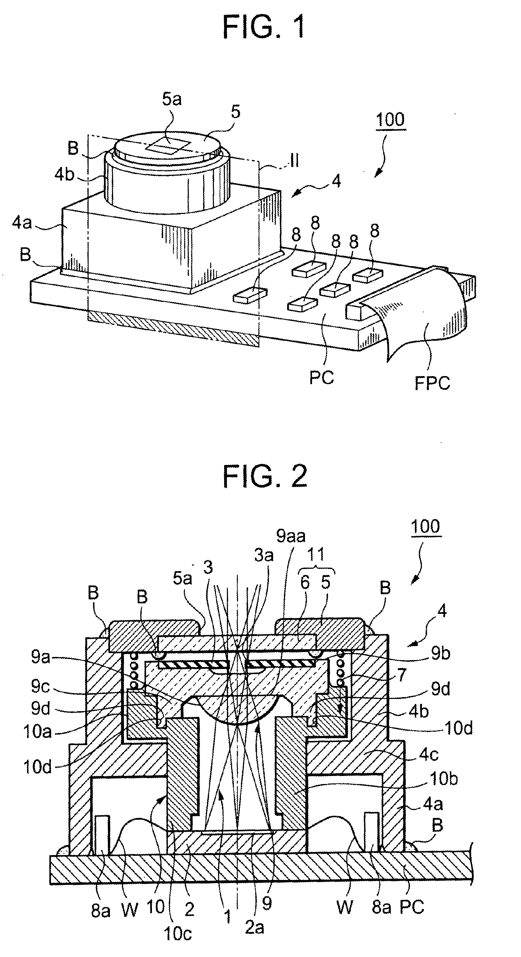

As shown in Figs. 1 and 2, an image sensing device 100 has a substrate PC, an image sensing element 2 disposed on one side of the surface of the substrate PC, an optical member 1 for focusing light on the image sensing region (a photoelectric converting portion 2a to be described later) of the image sensing element 2 to form the image of an object, an aperture plate 3 for adjusting the quantity of light that becomes incident on the optical member 1, a mirror frame 4 for covering the image sensing element 2, a light-shielding plate 5 having light-shielding properties, an IR cut filter 6 supported by the light-shielding plate 5, a pressing member 7 for pressing the optical member 1 toward the image sensing element 2, positioning electrical components 8a for positioning the mirror frame 4, other electrical components 8 arranged on the substrate PC, a flexible substrate FPC extending from the substrate PC, and the like.

As shown in Figs. 2 to 4, the optical member 1 is constituted by a lens member 9 made of a transparent plastic material, and a lens support member 10 which supports the lens member 9 and which is arranged on the image sensing element 2 to abut against it.

The lens member 9 integrally has a lens portion 9a having the shape of a convex lens, and a fitting portion 9c formed under the side of the lens portion 9a to fit with the lens support member 10. An upper surface portion 9b is formed on the upper end of the lens member 9, and the lens portion 9a is formed at the center of the upper surface portion 9b. The fitting portion 9c has projections 9d projecting downward.

The lens member 9 has a length of 10 mm or less in the direction of the optical axis of the lens portion 9a and a weight of 15 g or less, so that it can be used in a comparatively compact image sensing device.

The lens support member 10 is made of a light-shielding plastic material to prevent internal reflection by the lens member 9. A saucer-like support 10a which fits with the fitting portion 9c of the lens member 9 to support the lens member 9 is formed on the upper end of the lens support member 10. A tubular leg 10b is formed under the support 10a. Four abutting portions 10c to abut against the image sensing element 2 are formed under the leg 10b.

As shown in Fig. 2, the support 10a has recesses 10d to fit with the projections 9d of the lens member 9. Thus, the lens member 9 is fixed to the lens support member 10 and does not shift from a predetermined position.

Those surfaces of the abutting portions 10c which abut against the image sensing element 2 have uniform three-dimensional rough surfaces. These abutting surfaces serve as multi-point contacts on the image sensing element 2, so that they can disperse the load.

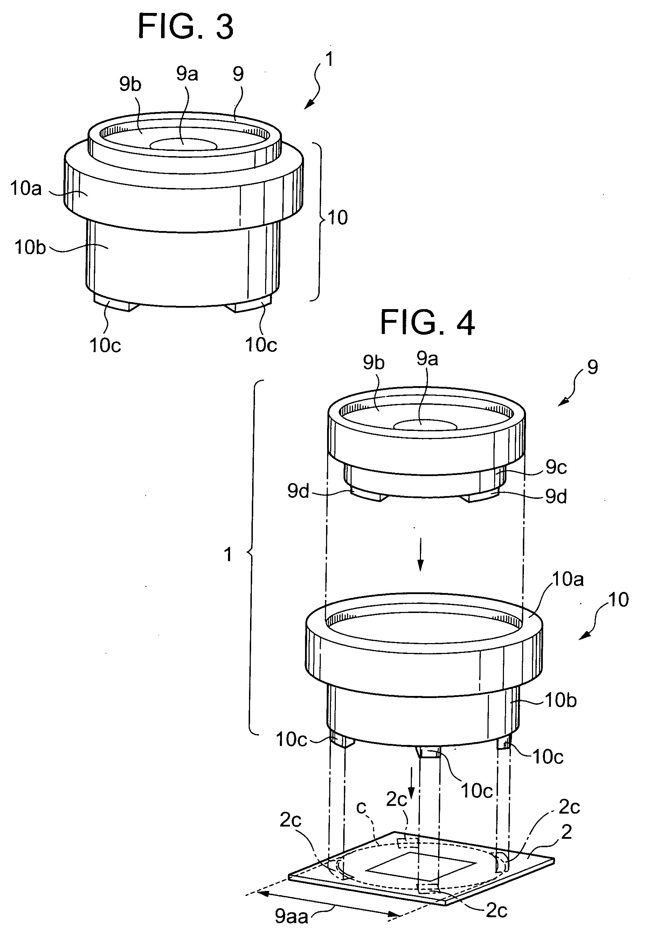

As shown in Fig. 4, the outer diameter of the lens member 9 is larger than the long side of the image sensing element 2. The outer end of the support 10a is located on the outer side of the long-side end of the image sensing element 2, but the leg 10b and abutting portions 10c of the lens support member 10 are located on the inner side of an effective diameter 9aa of the lens member 9. The abutting portions 10c are disposed, on an image non-sensing region 2b of the image sensing element 2, at positions inside a circle c corresponding to the effective diameter 9aa of the lens member 9 which is indicated by a broken line.

More specifically, although the lens member 9 with its size unchanged cannot be disposed on the image sensing element 2 directly, it can be disposed through the lens support member 10.

The image sensing element 2 is an image sensor, e.g., a CMOS image sensor, a CCD image sensor, or the like. The lower surface of the rectangular thin image sensing element 2 is attached to the upper surface of the substrate PC. As shown in Fig. 4, the photoelectric converting portion 2a having two-dimensional arrays of pixels and serving as an image sensing region is formed at the center of the upper surface of the image sensing element 2. To-be-abutted portions 2c, against which the abutting portions 10c of the lens support member 10 abut, and a processing portion (not shown) are formed in the image non-sensing region 2b on the outer side of the photoelectric converting portion 2a. The to-be-abutted portions 2c are located inside the circle c corresponding to the effective diameter 9aa of the lens portion 9a. A plurality of pads (not shown) are arranged in the vicinity of the outer edge of the processing portion. The pads serving as connection terminals are connected to the substrate PC through wires W, as shown in Fig. 2. The wires W are connected to predetermined circuits on the substrate PC.

The aperture plate 3 is fixed to the upper surface portion 9b around the lens portion 9a. The aperture plate 3 is made of a light-shielding material and has an opening 3a serving as the first aperture that regulates the aperture value (F value) of the lens portion 9a.

The mirror frame 4 is a housing made of a light-shielding material, and is arranged outside the optical member 1.

As shown in Figs. 1 and 2, the mirror frame 4 has a prismatic lower portion 4a and a cylindrical upper portion 4b. The lower end of the lower portion 4a is fixed to the substrate PC with an adhesive B. The inner surface of a partition 4c between the lower portion 4a and upper portion 4b of the mirror frame 4, and the leg 10b of the lens support member 10 of the optical member 1 tightly fit with each other. Through this fitting, the optical member 1 is regulated in position by the mirror frame 4 so that, e.g., its rotation about the optical axis of the lens portion 9a is prevented.

The optical member 1 is regulated in position by the mirror frame 4. Hence, when the mirror frame 4 is positioned and arranged at a predetermined position on the substrate PC on the basis of the positioning electrical components 8a (to be described later), the optical member 1 can be arranged at a predetermined position on the substrate PC. Then, for example, the center of the photoelectric converting portion 2a of the image sensing element 2 provided to the substrate PC and the center of the optical axis of the lens portion 9a of the optical member 1 fitted with the mirror frame 4 can coincide with each other.

The optical member 1 is regulated in position by the mirror frame 4. Hence, when the mirror frame 4 is arranged and fixed at the predetermined position on the substrate PC, the optical member 1 will not easily shift from its predetermined position. Thus, for example, a state wherein the center of the optical axis of the lens portion 9a of the optical member 1 and the center of the photoelectric converting portion 2a of the image sensing element 2 coincide with each other can be maintained easily.

The light-shielding plate 5 is attached to the upper end of the upper portion 4b of the mirror frame 4 with the adhesive B. The light-shielding plate 5 has an opening 5a serving as the second aperture at its center.

The IR cut filter 6 is made of an infrared-absorbing material, and is bonded below the opening 5a at the center of the light-shielding plate 5 with the adhesive B.

The light-shielding plate 5 and IR cut filter 6 constitute a cover member 11. In this manner, since the substrate PC, mirror frame 4, and cover member 11 are in tight contact with and bonded to each other, an image sensing portion 10 has a dust-proof, moistureproof structure.

The pressing member 7 is formed of an elastic material such as a coil spring, and is arranged between the optical member 1 and the light-shielding plate 6. When the light-shielding plate 5 is attached to the mirror frame 4, the light-shielding plate 5 presses the pressing member 7 to elastically deform it. The pressing member 7 presses the optical member 1 downward in Fig. 2 with a predetermined pressing force, to bias it toward the image sensing element 2. When the light-shielding plate 5 applies a force toward the image sensing element 2 below it, the pressing member 7 deforms elastically, so that a damping function of absorbing the elastic deforming force is effected. Hence, this force is not transmitted to the image sensing element 2 directly, thus preventing the image sensing element 2 from being broken.

The electrical components 8 are those that are necessary for actuating the image sensing device 100 to perform image processing. Since the electrical components 8 are formed on the substrate PC in this manner, the image sensing device 100 can be easily mounted on various types of electronic devices easily as one unit.

Each positioning electrical component 8a is, e.g., a capacitor, a resistor, a diode, or the like, and is arranged between the image sensing element 2 and the mirror frame 4 on the substrate PC in Fig. 2 to be close to the mirror frame 4. The height from the substrate PC to the upper ends of the positioning electrical components 8a is larger than the height from the substrate PC to the upper end of the image sensing element 2. Also, the positioning electrical components 8a comprise four positioning electrical components 8a to surround the four corners inside the fixing portion of the lower portion 4a of the mirror frame 4. Accordingly, the positioning electrical components 8a serve as positioning indices for the mirror frame 4 when fixing the mirror frame 4 onto the substrate PC. As the upper ends of the positioning electrical components 8a are higher than the upper end of the image sensing element 2, the mirror frame 4 is prevented from coming into contact with the image sensing element 2 to damage the wires W or the like of the image sensing element 2.

Each positioning electrical component 8a is not limited to, e.g., a capacitor, a resistor, or a diode, but can be any electrical component which is necessary for the image sensing device 100.

When the image sensing device 100 is to be mounted on an electronic device, the flexible substrate FPC are connected to the substrate or the like of the electronic device so that it serves as an external connection terminal.

In this manner, in the image sensing device 100 according to the first embodiment, the optical member 1 is constituted by the lens member 9 and lens support member 10. Thus, even when the leg 10b and abutting portions 10c of the optical member 1 of the image sensing element 2 are located inside the effective diameter 9aa of the lens portion 9a due to the structural element, e.g., the size, of the image sensing element 2 or photoelectric converting portion 2a, and furthermore even when the maximum length of a region surrounded by the bonding pad (not shown) arranged around the image sensing element 2 is smaller than the effective diameter 9aa of the lens portion 9a, the lens member 9 can be arranged as it is on the image sensing element 2. Therefore, assuming that the image sensing element 2 is available in various sizes and shapes, even when the lens member 9 is not formed to match the size or shape of the image sensing element 2, if the leg 10b of the lens support member 10 is located to match the size or shape of the image sensing element 2, the variations in size and shape of the image sensing element 2 can be coped with. More specifically, the image sensing element 2 can be manufactured without being influenced by the size of the lens member 9. Thus, the degrees of freedom in the manufacture of the image sensing element 2 and accordingly of the image sensing device 100 increase. For example, the image sensing element 2 can be formed to be smaller than the lens member 9. Since the image sensing element 2 can be formed small without being influenced by the size of the lens member 9, it can contribute to downsizing of the image sensing device 100.

The lens member 9 and the lens support member 10 are arranged such that the projections 9d of the lens member 9 and the recesses 10d of the lens support member 10 fit with each other. Thus, the state wherein the center of the optical axis of the lens portion 9a and the center of the photoelectric converting portion 2a of the image sensing element 2 coincide with each other can be maintained.

The shape, arrangement, and the like of the optical member 1 of the image sensing device 100 according to the first embodiment of the present invention are not limited to those described above.

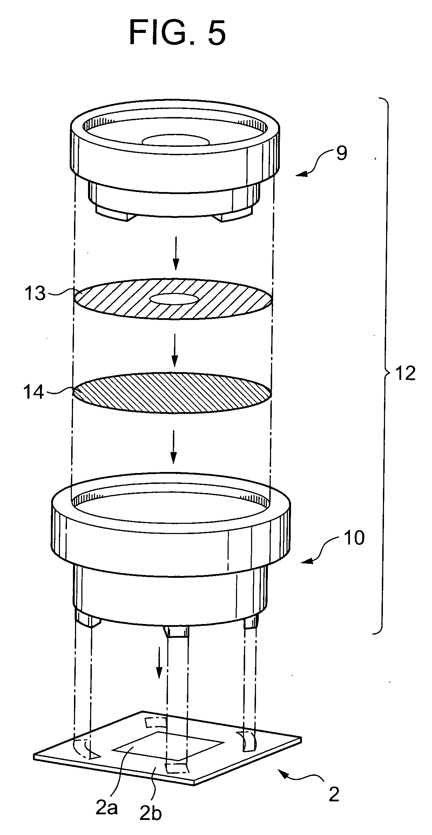

Modifications 12, 15, 18, and 21 of the optical member 1 will be described with reference to Figs. 5 to 8.

### (First Modification of First Embodiment)

The optical member 12 according to the first modification shown in Fig. 5 is constituted such that an aperture plate 13 and IR cut filter 14 can be disposed between a lens member 9 and lens support member 10. As indicated by the optical member 12, components such as an aperture plate, IR cut filter, and the like may be built between the lens member 9 and lens support member 10.

### (Second Modification of First Embodiment)

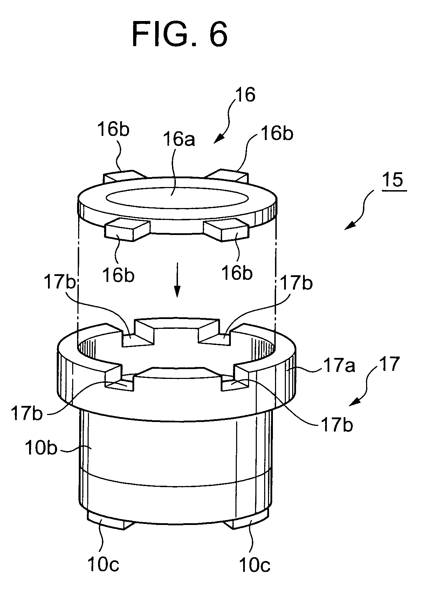

The optical member 15 according to the second modification shown in Fig. 6 is constituted by a lens member 16 having a cylindrical lens portion 16a, and a support member 17 for supporting the lens member 16.

Projections 16b for fitting with the support member 17 are formed on the lens member 16 such that they project in a direction perpendicular to the direction of the optical axis of the lens portion 16a. Recesses 17b serving as to-be-fitted portions that can fit with the projections 16b are formed in a support 17a formed at the upper end of the support member 17. Therefore, when the projections 16b of the lens member 16 are fitted in the recesses 17b of the support member 17, the lens member 16 is supported by the support member 17 and is positioned in a direction perpendicular to the direction of the optical axis of the lens member 16. As the recesses 17b open upward, the lens member 16 can be fitted in the support member 17 from above accurately, making assembly easy.

As the projections 16b, gates used when forming the lens member 16 with a mold may be used. In this case, the cost required by forming the projections 16b by molding can be economized.

### (Third Modification of First Embodiment)

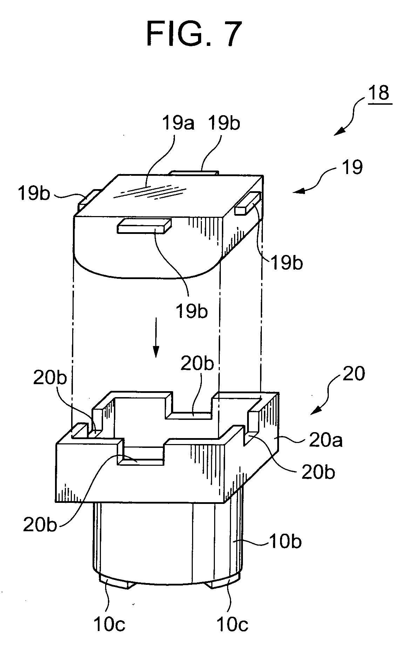

The optical member 18 according to the third modification shown in Fig. 7 is constituted by a lens member 19 having a finder-lens-like lens portion 19a, and a lens support member 20 for supporting the lens member 19.

Projections 19b for fitting with the lens support member 20 are formed on the lens member 19, such that they project in a direction perpendicular to the direction of the optical axis of the lens portion 19a. Recesses 20b serving as to-be-fitted portions that can fit with the projections 19b are formed in a support 20a of the lens support member 20. Thus, the finder-lens-like lens portion 19a can be built in the image sensing device accurately.

### (Fourth Modification of First Embodiment)

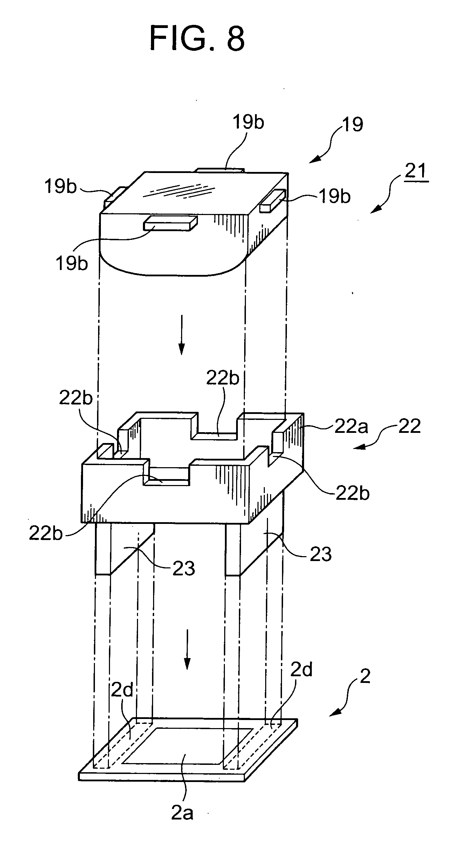

The optical member 21 according to the fourth modification shown in Fig. 8 is constituted by a lens member 19 identical to that shown in Fig. 7, and a lens support member 22 for supporting the lens member 19. Recesses 22b serving as to-be-fitted portions that can fit with projections 19b of the lens member 19 are formed in a support 22a of the lens support member 22. Two pairs of cubic legs 23 may be formed below the support 22a and recesses 22b, and may abut against to-be-abutted portions 2d of an image sensing element 2.

### Second Embodiment:

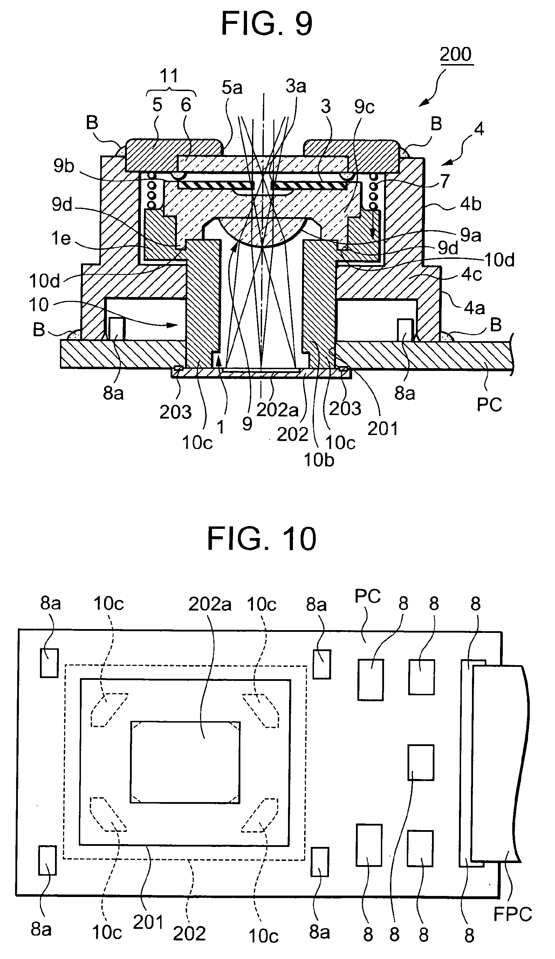

The second embodiment of the present invention will be described with reference to Figs. 9 and 10. The same portions as those in the first embodiment are denoted by the same reference numerals. Only portions that are different from their counterparts in the first embodiment will be described hereinafter.

As shown in Figs. 9 and 10, an image sensing device 200 is constituted by a substrate PC having an opening 201, an image sensing element 202 which closes the opening 201 from the lower surface of the substrate PC, an optical member 1 which abuts against a light-receiving surface as the surface of the image sensing element 202 from the upper surface of the substrate PC through the opening 201 to focus light on the image sensing element 202, an aperture plate 3 which adjusts the quantity of light that becomes incident on the optical member 1, a mirror frame 4 which serves as an outer frame member for covering the image sensing element 202 and opening 201, a light-shielding plate 5 provided to the mirror frame 4 and having light-shielding properties, a filter 6 supported by the light-shielding plate 5, a pressing member 7 arranged between the light-shielding plate 5 and optical member 1 to press the optical member 1 toward the substrate PC, positioning electrical components 8a arranged at predetermined positions on the substrate PC to position the optical member 1, other electrical components 8 arranged on the substrate PC, a flexible substrate FPC serving as an external connection terminal extending from the substrate PC, and the like.

For example, the image sensing element 202 is a CMOS image sensor, a CCD image sensor, or the like. The upper surface at the end of the thin, rectangular image sensing element 202 is attached to the lower surface of the substrate PC. A rectangular photoelectric converting portion 202a having two-dimensional arrays of pixels and serving as an image sensing region is formed at the center of the upper surface of the image sensing element 202. When the image sensing element 202 is attached to the lower surface of the substrate PC, the photoelectric converting portion 202a exposes from the upper surface of the substrate PC through the opening 201 formed in the substrate PC.

The upper surface at the end of the image sensing element 202 and the lower surface of the substrate PC are attached to each other through bumps 203 serving as electrodes. The image sensing element 202 and substrate PC are electrically connected to each other through the bumps 203.

In more detail, bonding pads (not shown) serving as connection members for connection with the image sensing element 202 are arranged on the lower surface of the substrate PC. The bumps 203 are formed on input/output terminals (not shown) formed at positions on the image sensing element 202 which correspond to the bonding pads around the photoelectric converting portion 202a. The input/output terminals of the image sensing element 202 and the bonding pads of the substrate PC are bonded to each other through the bumps 203. Thus, the image sensing element 202 and substrate PC are electrically connected to each other. As a bonding method, for example, other than ultrasonic welding, an ACF (Anisotropic Conductive Film), an ACP (Anisotropic Conductive Paste), or the like may be used.

In this manner, in the image sensing device 200 according to the second embodiment, the image sensing element 202 is arranged to close the opening 201 of the substrate PC from the lower surface of the substrate PC, and the optical member 1 is arranged such that it abuts against the photoelectric converting portion 202a of the image sensing element 202 from the upper surface of the substrate PC through the opening 201. Thus, projection of the optical member 1 from the upper surface of the substrate PC in the perpendicular direction can be suppressed by an amount corresponding to the thickness of the substrate PC. Hence, the thickness of the image sensing device 200 can be reduced by suppressing projection of the optical member 1.

### Third Embodiment:

The third embodiment of the present invention will be described. The same portions as those in the first and second embodiments described above are denoted by the same reference numerals, and a detailed description thereof will be omitted. Only portions that are different from their counterparts in the first and second embodiments will be described hereinafter.

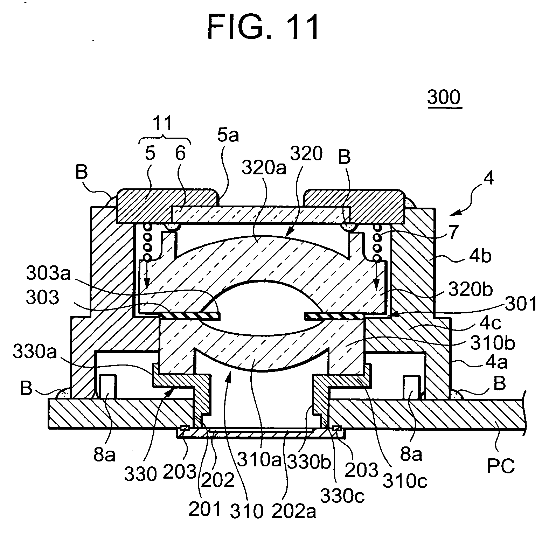

Fig. 11 is a partially omitted sectional view of an image sensing device 300 according to the third embodiment of the present invention.

As shown in Fig. 11, an optical member 301 of the image sensing device 300 is constituted by a first lens member 310, a second lens member 320 serving as an auxiliary optical member which is arranged above the first lens member 310 through an aperture plate 303 which adjusts the quantity of light that becomes incident on the first lens member 310, and a lens support member 330 which supports the first lens member 310 and abuts against the surface of an image sensing element 202 from the upper surface of a substrate PC through an opening 201. The optical axis of the first lens member 310 and that of the second lens member 320 are identical.

The first lens member 310 has a tubular lower leg 310b around its lens portion 310a. An abutting portion 310c which abuts against the lens support member 330 is formed at the lower end of the lower leg 310b. The outer portion of the first lens member 310 abuts against a partition 4c of a mirror frame 4 such that the first lens member 310 fits with the partition 4c. This makes positioning of the first lens member 310 reliable.

The aperture plate 303, made of a light-shielding material and having an opening 303a as an aperture that regulates the F-number of the lens portion 310a, is fixed to the upper surface of the tubular lower leg 310b of the first lens member 310 and around the lens portion 310a with an adhesive.

The second lens member 320 has a tubular upper leg 320b around its lens portion 320a. The aperture plate 303 is fixed to the lower surface of the upper leg 320b with an adhesive. The second lens member 320 presses the second lens member 320 downward in Fig. 11 with a predetermined pressing force by a pressing member 7 arranged between the second lens member 320 and a light-shielding plate 5, to bias the first lens member 310 toward the image sensing element 202 through the aperture plate 303.

The lens support member 330 is made of a light-shielding plastic material for preventing internal reflection of the first lens member 310. The lens support member 330 has a saucer-like support 330a formed at the upper end of the lens support member 330 to abut against the abutting portion 310c of the lens member 9 to support the first lens member 310, a tubular leg 330b formed on the lower portion of the support 330a, and four abutting portions 330c formed on the lower portion of the leg 330b to abut against the image sensing element 202.

In this manner, in the image sensing device 300, the first lens member 310 and second lens member 320 are used in a complex manner as the optical member 301. Since the optical functions and the like of the first and second lens members 310 and 320 are combined, the range of the function as an optical member can be widened. As a result, a higher-function image sensing device, even though it is compact, can be obtained.

Projections may be formed on the lower portion of the abutting portion 310c of the first lens member 310, and the support 330a of the lens support member 330 may have recesses that can fit with the projections. In this case, the first lens member 310 and lens support member 330 are fixed more securely, so that they are prevented from shifting from predetermined positions.

A portable terminal in which the image sensing device is mounted will be described by way of an image sensing device 100.

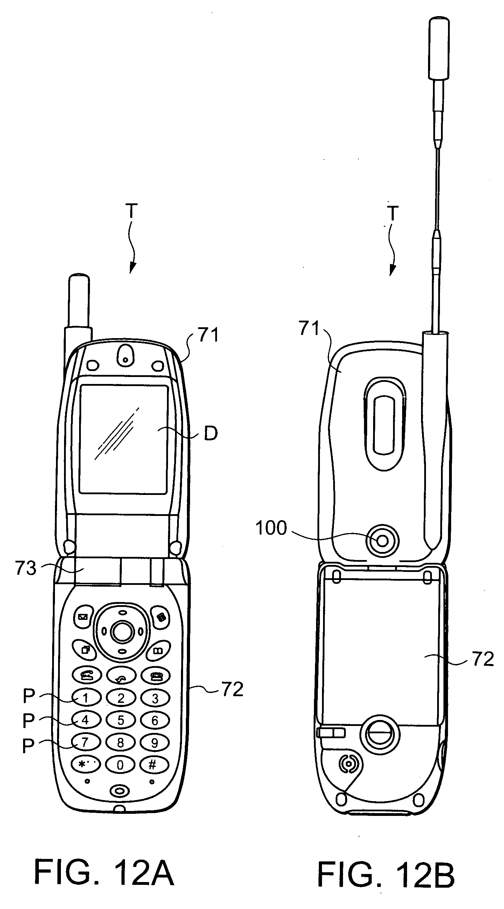

As shown in Figs. 12A and 12B, the example of the portable terminal of the present invention is, e.g., a foldable portable cellular phone set T (to be merely referred to as a portable cellular phone set T hereinafter). An upper housing 71 serving as a case having a display screen D and a lower housing 72 having operation buttons P are connected to each other through a hinge 73 such that they can be opened/closed. The image sensing device 100 is incorporated below the display screen D formed on the inner surface (the surface having the display screen D) of the upper housing 71. The image sensing device 100 (optical member 1) can obtain light from the outer surface of the upper housing 71.

When the low-profile image sensing device 100 is incorporated in the portable cellular phone set T in this manner, the portable cellular phone set T can have a lower profile. If the functions of the image sensing device 100 are selectively used in accordance with the distance from the image sensing target and the image sensing atmosphere, the portable cellular phone set T can have a high value added. Other constituent elements of the portable cellular phone set T are known, and a detailed description thereof will accordingly be omitted.

In the portable cellular phone set T described above, the image sensing device 100 described in the first embodiment is mounted. Alternatively, the image sensing device 200 or 300 described in the second or third embodiment may be used instead. In this case, the projection amount of the optical member 1 in the direction of the optical axis decreases by an amount corresponding to the thickness of the substrate PC. Thus, a lower-profile portable cellular phone set T is realized.

Several embodiments and modifications of the present invention have been described so far. Note that the present invention should not be understood limitedly to the above embodiments and modifications, but can be changed and improved when necessary. For example, in the second and third embodiments, the optical member 1 described in the first embodiment is used. Alternatively, the optical member 12, 15, 18, or 21 as a modification of the optical member 1 may be mounted.

Regarding the various types of optical members described above, the shapes and the like of the lens member and lens support member that form the optical member are not limited to those described above. For example, the shapes, number, and the like of the fitting portions of the lens member and lens support member are not limited. Similarly, in the lens support member, the shapes, number, and the like of the legs that abut against the image sensing element are not limited. For example, the lens support member and the image sensing element may abut against each other through a rough surface, or through a tight-contact surface.

The substrate PC is not limited to a hard one but can be a flexible one.

Although a CMOS image sensor is used as the image sensing element 2 or 200 in the above embodiments, a CCD (Charge Coupled Device) image sensor may be used as the image sensing element.

The image sensing device according to the present invention can be incorporated in various types of equipments, e.g., a portable cellular phone, a personal computer, a PDA, an AV device, a television set, a household electrical appliance, and the like.

## Claims

1. An image sensing device comprising a substrate having an image sensing element, and an optical member for forming an image of an object on an image sensing region of said image sensing element, wherein said optical member comprises
a lens member, and
a lens support member which has a support for supporting said lens member and which is arranged to abut against an image non-sensing region of said image sensing element.

2. An image sensing device comprising a substrate having an opening, an image sensing element attached to a lower surface of said substrate to close at least part of the opening, and an optical member for forming an image of an object on an image sensing region of said image sensing element, wherein said optical member comprises
a lens member, and
a lens support member which has a support for supporting said lens member and which is arranged to abut against an image non-sensing region of said image sensing device from an upper surface of said substrate through the opening.

3. A device according to claim 1 or 2, wherein an outer end of said support is located on an outer side of said image sensing element.

4. A device according to any one of claims 1 to 3 wherein, in said support, said lens member fits with said lens support member.

5. A device according to claim 4, wherein said lens member has a projection projecting in a direction perpendicular to a direction of an optical axis, and said support has a recess which is to fit with said projection and which opens upward.

6. A device according to any one of claims 1 to 5, wherein said lens support member has light-shielding properties.

7. A device according to any one of claims 1 to 6, wherein at least one of an aperture plate and an IR cut filter is inserted between said lens member and said lens support member.

8. A device according to any one of claims 1 to 7, wherein an abutting surface of said lens support member which abuts against the image non-sensing region of said image sensing element has a uniform three-dimensional surface.

9. An image sensing device comprising an image sensing portion including an image sensing element having a photoelectric converting portion, a substrate for holding said image sensing element and having an external connection terminal for an electrical signal, an optical member for forming an image of an object on said photoelectric converting portion, and a housing having an opening and made of a light-shielding member to cover said 5 optical member, said optical member having a height of not more than 10 mm in a direction of an optical axis, wherein said optical member comprises
a lens member, and
a lens support member for supporting said lens member 10 and arranged to abut against an image non-sensing region of said image sensing element.

10. A portable electronic device wherein an image sensing device according to any one of claims 1 to 9 is mounted in a case thereof.
